# EUROPEAN PATENT SPECIFICATION

(11) **EP 1 781 078 B1**
(45) Date of publication and mention of the grant of the patent: **07.12.2011**
(21) Application number: 06022677.6
(22) Date of filing: 31.10.2006
(51) Int. Cl.: H05K 13/04

(54) **Electronic component mounting apparatus**
Elektronische Bauteile-Bestückungsvorrichtung
Appareil pour monter des composants électroniques

(30) Priority: 31.10.2005 JP 2005317304
(43) Date of publication of application: 02.05.2007
(73) Proprietor: Hitachi High-Tech Instruments Co., Ltd., Ora-gun, Gunma, 370-0596 (JP)
(72) Inventor: Ieizumi, Kazuyoshi, Ota-shi, Gunma 373-0813 (JP); Aoki, Akira, Ota-shi, Gunma 373-0026 (JP); Kameda, Makio, Ota-shi, Gunma 373-0808 (JP); Fukushima, Yoshiharu, Oizumi-machi, Ora-gun Gunma 370-0514 (JP); Kashitani, Hisayoshi, Ota-shi, Gunma 373-0806 (JP)
(74) Representative: Glawe, Delfs, Moll

(56) References cited:
- EP-A- 1 521 515
- US-A- 5 864 944
- US-A1- 2002 178 578

## Description

### BACKGROUND OF THE INVENTION

### Field of the Invention

The invention relates to an electronic component mounting apparatus having a plurality of component feeding units feeding an electronic component to a component pickup position and a mounting head that has a suction nozzle picking an electronic component by suction from this component feeding unit and mounting this electronic component on a printed board and moves vertically, rotates, and moves in X and Y directions.

### Description of the Related Art

This kind of electronic component mounting apparatus has been described, for example, the Japanese Patent Application Publication No. 2001-156498. For picking an electronic component fed from the component feeding unit by the suction nozzle, some of the apparatuses rotate the mounting head provided with the suction nozzle to adjust the nozzle at an angle in a θ direction where the electronic component is to be fed, and vertically move the mounting head to pick the electronic component up by suction. Between a rotation motor and a vertical movement motor of the mounting head, before the rotation motor of the mounting head is started, the operation pattern of the vertical movement motor, i.e., the start point of the vertical movement motor of the mounting head, that is the position the mounting head reaches by its rotation driven by the rotation motor, and the component feeding position of the feeding unit that is the target position of the mounting head moving for picking the electronic component by suction are set in a memory of a control device in advance. The current position of the mounting head during its rotation, the position of the mounting head during its movement in the X and Y directions, and the feeding state of the electronic component fed toward the feeding position by the component feeding unit are monitored by the control device. When the previously set start point and the current position of the suction head rotated by the rotation motor match, the mounting head reaches the component feeding position by moving in the X and Y directions, and further the electronic component is fed to the feeding position of the component feeding unit, the control device outputs a start signal to the vertical movement motor to start the vertical movement motor.

When an electronic component is to be picked up, the rotating position and the moving state in the X and Y directions of the mounting head are always monitored by the control device and the feeding state of the electronic component is monitored by the component feeding unit. At the time when all the conditions are satisfied, the control device outputs a start signal for the vertical movement motor to a drive circuit of that motor, and the drive circuit starts the vertical movement motor based on this start signal. Therefore, it takes time for the vertical movement motor to actually start driving from the time when the control device outputs the start signal for the vertical movement motor when all the conditions are satisfied. A mounting time per electronic component has not been reduced so far.

It is thus an object of the invention to provide an improved apparatus allowing a reduction in mounting time per electronic component.

Another electronic component mounting apparatus is described in EP 1 521 515 A2.

### SUMMARY OF THE INVENTION

The solution according to the invention resides in the features of independent claim 1 and preferably in those of the dependent claims.

The invention is directed to reduction of a mounting time per electronic component by starting a vertical movement motor and so on as early as possible.

The invention provides an electronic component mounting apparatus as recited in claim 1.

### BRIEF DESCRIPTION OF THE DRAWINGS

Fig. 1 is a plan view of an electronic component mounting apparatus.
Fig. 2 is a front view of the electronic component mounting apparatus.
Fig. 3 is a right side view of the electronic component mounting apparatus.
Fig. 4 is a control block diagram of the electronic component mounting apparatus.
Fig. 5 is a longitudinal cross-sectional view of a front of a mounting head body holding a thin electronic component by suction.
Fig. 6 is a longitudinal cross-sectional view of a side of the mounting head body.
Fig. 7 is a plan view of a fixing support piece and a vertical movement support piece.
Fig. 8 is a schematic bottom view of the mounting head.

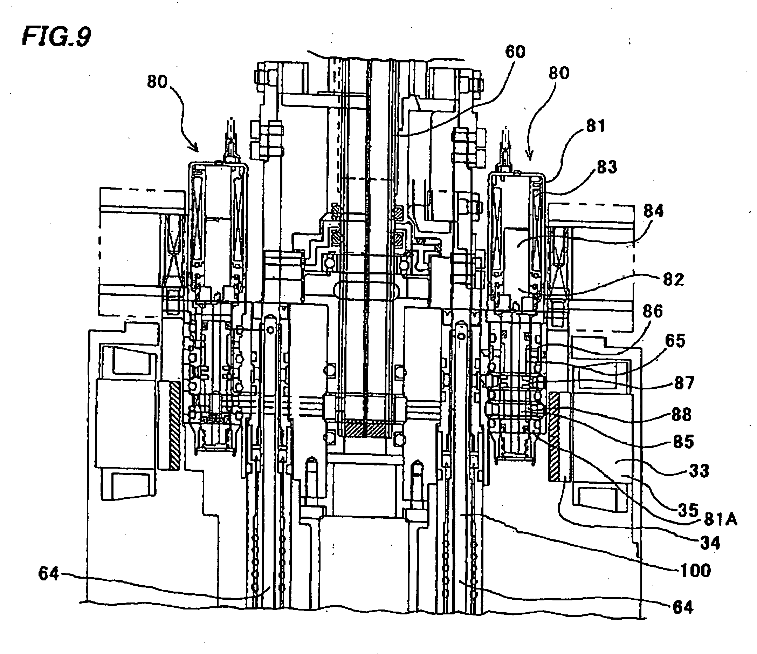

Fig. 9 is an enlarged longitudinal cross-sectional view of a front of a lower portion of the mounting head.
Fig. 10 is a view showing an operation screen displayed on a CRT.
Fig. 11 is a flowchart of detection by a line sensor unit.
Fig. 12 is a flowchart of detection by a component recognition camera.
Fig. 13 is a flow chart of picking an electronic component by suction.

### DETAILED DESCRIPTION OF THE INVENTION

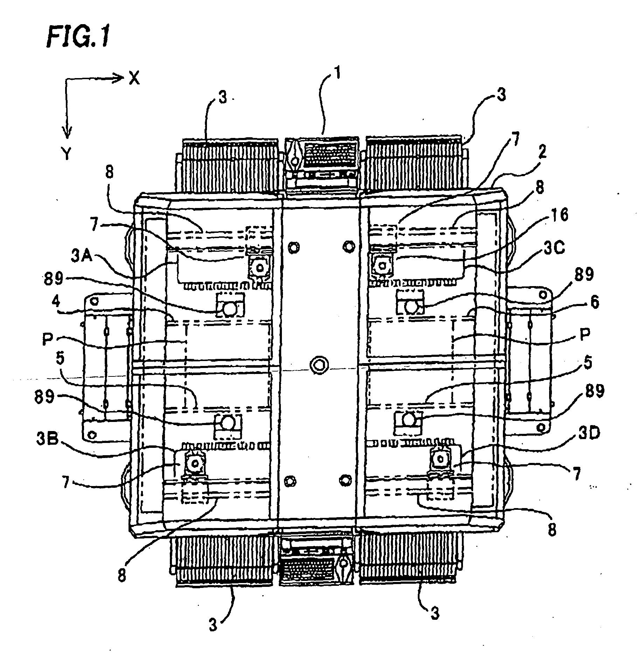

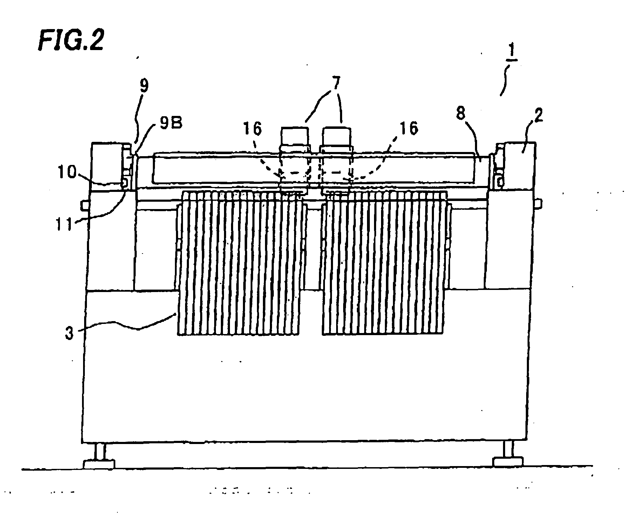

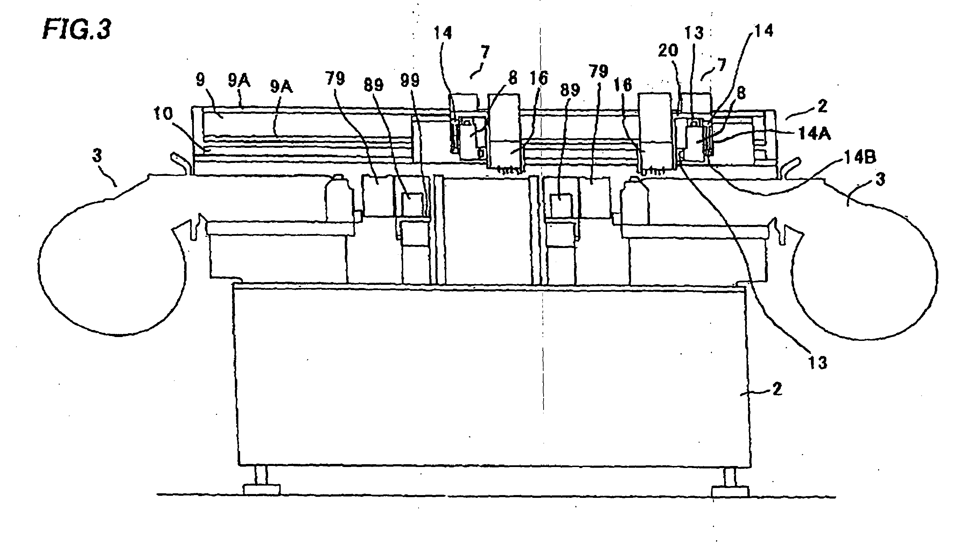

An embodiment of an electronic component mounting apparatus of the invention will be described with reference to the drawings. Fig. 1 is a plan view of an electronic component mounting apparatus 1, Fig. 2 is a front view of the electronic component mounting apparatus 1, and Fig. 3 is a right side view of the electronic component mounting apparatus 1. A plurality of component feeding units 3 for feeding a variety of electronic components one by one to each of component feeding positions (component pickup positions) is attachably and detachably aligned and fixed on feeder bases 3A, 3B, 3C, and 3D on a base 2 in the apparatus 1. A feed conveyer 4, a positioning portion 5, and a discharge conveyer 6 are provided between groups of the units 3 facing to each other. The feed conveyer 4 conveys a printed board P received from an upstream to the positioning portion 5, an electronic component is mounted on the printed board P positioned by a positioning device (not shown) in the positioning portion 5, and the printed board P is conveyed to the discharge conveyer 6.

A numeral 8 designates a pair of beams extending in an X direction. Each of the beams 8 respectively moves in a Y direction above the printed board P on the positioning portion 5 or the component feeding positions (component pickup positions) of the component feeding units 3 as sliders 11 fixed to each of the beams 8 slide along a pair of left and right guides 10, driven by each of linear motors 9 provided in the Y direction. Each of the linear motors 9 provided in the X direction has a pair of upper and lower stationary members 9A fixed on the base 2 and a moving member 9B fixed to a lower part of an attachment board 8A provided on each end of the beam 8.

Each of the beams 8 is provided with a mounting head body 7 which moves in a longitudinal direction, i.e., in the X direction along a guide 13 driven by the linear motor 14. The linear motor 14 has a pair of front and back stationary members 14A fixed to the beam 8 and a moving member 14B provided on the mounting head body 7 and between the stationary members 14A.

Each of the mounting head bodies 7 has a mounting head 16 having twelve suction nozzles 15 each fixed to and pulled down by each of twelve springs 12. A board recognition camera 19 is provided on the mounting head 16 in each of the mounting head bodies 7 and takes an image of a positioning mark (not shown) on the printed board P positioned on the positioning portion 5.

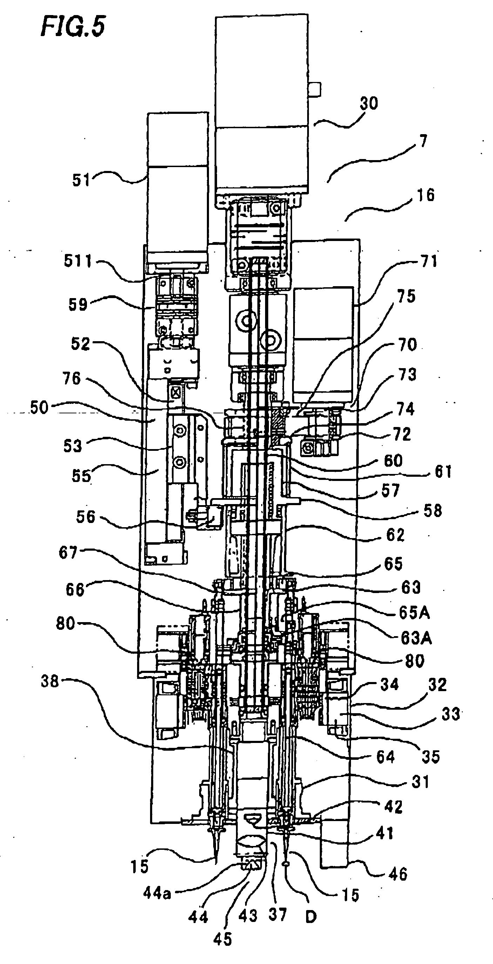

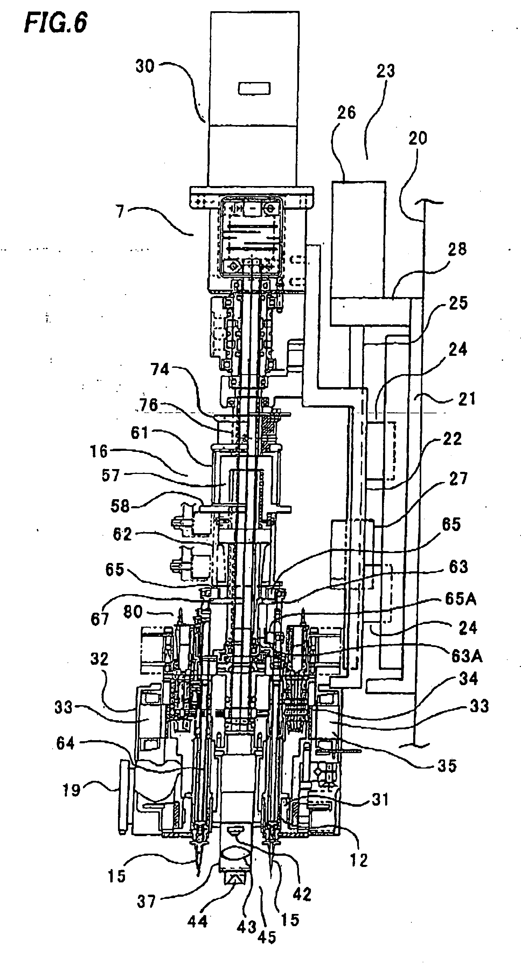

A vertical movement device for the mounting head 16 and the mounting head 16 will be described in detail with reference to Figs. 5 and 6. A numeral 20 designates a board of the mounting head body 7 moving along the guide 13, and a numeral 21 designates a beam side base fixed to this board 20. A numeral 22 designates a mounting head side base fixed to upper and lower portions of the mounting head 16. A head vertical movement device 23 is provided between this mounting head side base 22 and the beam side base 21.

The head vertical movement device 23 has a guide 24 guiding the mounting head 16 when the mounting head 16 vertically moves, a ball screw 25 attached to the beam side base 21, a rotation motor (referred to as a head vertical movement motor, hereafter) 26 vertically moving the mounting head 16 by rotating the ball screw 25, a vertical movement nut 27 engaged with the ball screw 25, and a support body 28 attached to the head vertical movement motor 26 and rotatably supporting an upper portion of the ball screw 25. The vertical movement nut 27 is fixed to the head side base 22. Thus, rotation of the ball screw 25 by rotation of the head vertical movement motor 26 makes the vertical movement nut 27 vertically move, resulting in vertical movement of the mounting head 16.

A numeral 30 designates a slip ring provided for communication between the mounting apparatus and the mounting head 16 and for power supply to a rotation motor of a nozzle support portion which will be described below. A numeral 31 designates a nozzle support body provided in a lower portion and supporting each of twelve nozzles 15 provided on a circumference thereof at predetermined intervals, which are vertically movable. A numeral 32 designates an outer cylinder in a lower portion, and a numeral 33 designates a nozzle rotation motor as a pulse motor for θ rotation provided between the outer cylinder 32 and the nozzle support body 31. A rotor 34 of this nozzle rotation motor 33 is provided on an outer circumference surface of the nozzle support body 31, being rotatable in a θ direction inside a stator 35 provided in the outer cylinder 32 together with the nozzle support body 31.

A numeral 37 designates a line sensor unit for detecting presence or absence, an attached posture, and a lower end of the electronic component, protruding downward from a center of the head support body 31. The line sensor unit 37 has a light emitting unit 45 and a light receiving unit 46. The light emitting unit 45 is provided in a lower end of the support body 38 in the almost center position of the mounting head 16, and has a light emitting element 42 such as an LED in an upper part of a cylindrical light emitting unit attachment body 41, a lens 43 below the light emitting element 42, and a reflector 44 having a conic reflective surface 44a provided below the lens 43. A light receiving unit 46 is fixed to a bottom surface of the outer cylinder 32, and has CCD elements as a plurality of light receiving elements for receiving light emitted from the light emitting element 42 through the reflector 44.

This enables differentiating a case where the electronic component is picked up with a normal position as shown in Fig. 5 from a case where the component is picked up with its wrong surface being attached to the suction nozzle, i.e., standing or slanting, since height of a lower end surface of the electronic component D can be detected by recognizing a border between the position receiving no light and the position receiving light in each of the CCD elements in each time when the nozzle support body 31 rotates after a pickup operation of the electronic component D is completed by the suction nozzle 15 provided on the mounting head 16 and selected for picking the component. In detail, after the suction nozzle 15 lowers, picks the electronic component D up from the component feeding unit 3 by suction, and rises up, the nozzle rotation motor 33 is driven to rotate the nozzle support body 31 and rotate the suction nozzle 15 holding the electronic component D by suction. When the electronic component D held by the suction nozzle 15 comes between the reflector 44 and the light receiving unit 46 during rotation of the suction nozzle 15, presence or absence and an attached posture of the component can be detected by detecting height of the lower end surface of the electronic component D at plural positions. Although the detection is performed during rotation and movement of the nozzle support body 31 in this embodiment, alternatively the detection can be performed with the rotation being stopped when the electronic component D comes between the reflector 44 and the light receiving unit 46.

In a case where the suction nozzle 15 does not hold the electronic component D by suction, light emitted from the light emitting element 42, which should be shielded (by the held electronic component), is received by the light receiving unit 46. Thus, a detection result is "absence" of the electronic component D, so that by an operation of a solenoid valve 82 as a vacuum valve switch effector, which will be described below, provided on a side of each of the nozzle axes 64, a vacuum path is disconnected from a vacuum source to stop the vacuum suction, thereby preventing leakage. In a case where the electronic component is detected as being attached to the suction nozzle 15 at its wrong surface, i.e., with standing or slanting, the mounting head 16 and the suction nozzle 15 move to a position above an exhaust box 79, drops the electronic component D therein, and performs a picking process of the electronic component D again.

Even in a case where the electronic component is detected as being attached normally, a lower end level (lower end position) of the electronic component D can be detected so that a CPU 90 controls and changes an amount of a lowering stroke of the suction nozzle 15 for mounting the component D on the printed board P, corresponding to the lower end level. This compensates dimensional variations of the components caused by different manufacturers and so on.

A numeral 50 designates a nozzle vertical movement device provided on the mounting head 6. Description will be given on this nozzle vertical movement device, hereafter. A numeral 51 designates a motor for vertically moving a nozzle (referred to as a nozzle vertical movement motor, hereafter) attached to the head side base 22, and a numeral 52 designates a ball screw connected with a rotation axis 511 of the nozzle vertical movement motor 51 through a connection member 59 and rotating driven by the nozzle vertical movement motor 51, a numeral 53 designates a vertical movement body engaged with the ball screw 52 and vertically moving by rotation of the ball screw 52, a numeral 55 designates a guide attached to the head side base 22 and guiding the vertical movement body 53 for vertical moving, and a numeral 56 designates a roller rotatably attached to a lower end of the vertical movement body 53.

Furthermore, a numeral 57 designates a first cylinder where a center axis 60 of the mounting head 16 penetrates a center thereof, a roundel 58 formed on the first cylinder 57 is positioned on the roller 56, the fist cylinder 57 being supported by the roller 56. The first cylinder 57 is formed of a ball spline, for example, and pulled downward by a spring 61 of which a lower end is attached to an upper surface of the roundel 58. This first cylinder 57 rotates by e with θ rotation of a pulley which will be described below, and vertically moves together with a vertical movement of the vertical movement body 53 and a vertical movement of the roller 56. A numeral 62 designates a nozzle support member fixed to a lower portion of the first cylinder 57 and rotates by θ with the first cylinder 57. A support piece 63 is formed on a lower end of this nozzle support member 62, horizontally lying in a circumference direction. This support piece (referred to as a vertical movement support piece) 63 vertically moves together with vertical movement of the first cylinder 57. The lowering of the vertical movement support piece 63 makes a predetermined nozzle 15 among a plurality of nozzles lower.

In detail, a roller 65 is rotatably attached to an upper end of each of the nozzle axes 64 extending upward from each of the nozzles 15. The roller 65 on the upper end of the nozzle axis 64 of the nozzle 15 selected by a nozzle selection device which will be described below lowers by lowering of the nozzle support member 62 and the vertical movement support piece 63 by lowering of the first cylinder 57, the roller 65 being positioned on an upper surface of the vertical movement support piece 63. In detail, when the vertical movement support piece 63 and the roller 65 lower to a position shown by the vertical movement support piece 63A and the roller 65A, for example, the predetermined nozzle 15 lowers with this lowering. Furthermore, by controlling a rotation amount of the nozzle vertical movement motor 51 and adjusting a height where the vertical movement body 53 should stop during lowering, the suction nozzle 15 can lower by a predetermined stroke.

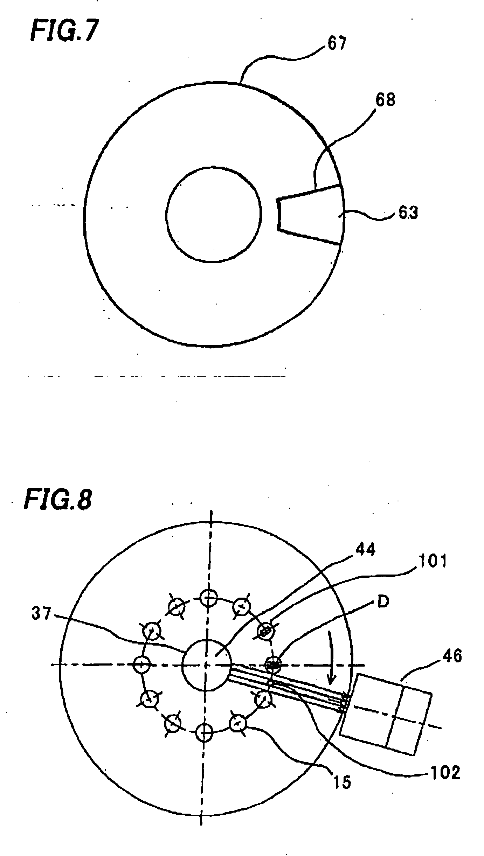

A numeral 66 designates a third cylinder provided under the nozzle support member 62, which is rotatable by θ. On an upper portion of this third cylinder 66, a support piece (referred to as a fixing support piece, hereafter) 67, which has a disk like shape, is formed at the same height as that of the vertical movement support piece 63 of the nozzle support member 62 before lowered. The fixing support piece 67 is formed with a notch 68 for the vertical movement support piece 63 as shown in Fig. 7. Each of the rollers 65 on the upper ends of the nozzle axes 64 of the nozzles 15 except the above-described nozzle 15 to be lowered is supported by the fixing support piece 67. That is, the fixing support piece 67 has the notch 68 formed in a position of one of some-degree divided pieces thereof calculated by dividing the piece 67 equally into the same number of pieces as the number of the nozzles 15 in a circumference direction, for example, in a position of a 30-degree piece which is one of 12 divided pieces in this embodiment. The vertical movement support piece 63 of the nozzle support member 62 is positioned in this notch 68.

A numeral 70 is a nozzle selection device provided on the mounting head 16, a numeral 71 designates a motor for selecting a nozzle to be lowered (referred to as a nozzle selection motor, hereafter), a numeral 72 designates a first pulley fixed to a rotation axis 73 of the nozzle selection motor 71, a numeral 74 designates a second pulley rotatably supported by the center axis 60, a numeral 75 designates a belt stretched between the first pulley 72 and the second pulley 74, and a numeral 76 designates a cylindrical rotator provided on an outside of the center axis 60, extending downward from a center of the second pulley 74. The spring 61 is provided between the second pulley 74 and the roundel 58 of the first cylinder 57.

The first cylinder 57 is formed on an outside of outer circumference of the lower portion of the rotator 76. By the function of the first cylinder 57 as a ball spline, the first cylinder 57 rotates with rotation of the second pulley 74 and rotation of the rotator 76. Furthermore, the first cylinder 57 vertically moves with vertical movement of the vertical movement body 53 along the rotator 76.

In detail, when the nozzle for picking and mounting the electronic component D is to be selected, the nozzle selection motor 71 rotates, so that the first cylinder 57 rotates through the first pulley 72, the belt 75, the second pulley 74, and the rotator 76. Then, the nozzle support member 62 connected with the first cylinder 57 rotates together with the third cylinder 66, so that the vertical movement support piece 63 of the nozzle support member 62 comes to the nozzle axis 64 extending from the selected nozzle 15. With this state, the nozzle vertical movement motor 51 rotates, and the vertical movement body 53 lowers corresponding to the thickness of the electronic component to be picked up and mounted, so that the first cylinder 57 and the nozzle support member 62 lower and thus the vertical movement support piece 63 lowers, thereby lowering only the selected nozzle 15 by a predetermined stroke corresponding to the thickness of the electronic component.

A numeral 80 is an air switch valve switchable in each of the nozzles 15, being provided for each of the nozzles 15 at predetermined intervals in the circumference direction on the outer side of the nozzles. This air switch valve 80 has a case 81 provided in an upper portion thereof, and a solenoid valve 82 of which the upper portion is positioned inside this case 81 and electrical conduction is controlled by a signal from the CPU 90. The solenoid valve 82 has a circular electromagnet 83 provided on an inner surface of the case 81, a path switch body 85 provided with a cylindrical permanent magnet 84 corresponding to the electromagnet 83 in its upper portion and vertically moving inside the case 81 according to electrical conduction and electrical non-conduction through the electromagnet 83, and so on. An air blow path (referred to as an air path, hereafter) 86, a nozzle connection path 87, and a vacuum leading path (referred to as a vacuum path, hereafter) 88 are formed on an outer circumference surface of the path switch body 85 in due order from upper to lower sides. Furthermore, the nozzle axis 64 has a nozzle axis path 100 connected with an inner path 151 of the nozzle 15 and the nozzle connection path 87. By the vertical movement of the path switch body 85, the connection of the nozzle path 100 switches to between the vacuum path 88 and the air path 86.

In detail, when the path switch body 85 rises by electrical conduction through the electromagnet 83, the vacuum path 88 and the nozzle connection path 87 are connected to each other, and the nozzle connection path 87 and the air path 86 are disconnected from each other. Therefore, the inner path 151 of the suction nozzle 15 is connected to a vacuum source (not shown) through the nozzle axis path 100, the nozzle connection path 87, and the vacuum path 88, so that the suction nozzle 15 keeps vacuum suction of the electronic component. On the other hand, when the connection switch body 85 lowers by electrical non-conduction through the electromagnet 83, the vacuum path 88 connected with the vacuum source and the nozzle connection path 87 are disconnected from each other, and the nozzle connection path 87 and the air path 86 are connected to each other. Therefore, the vacuum suction of the electronic component D by the suction nozzle 15 stops, and air from an air supply source is blown in the inner path 151 of the suction nozzle 15 through the air path 86, the nozzle connection path 87, and the nozzle axis path 100.

In this manner, the connection of the suction nozzle 15 with the vacuum source and the air supply source can be switched by electrical conduction and electrical non-conduction of the air switch valve 80 provided for each of the suction nozzles 15. Thus, the air switch valve 80 for the selected suction nozzle 15 can be switched independently.

A numeral 89 designates a component recognition camera. The component recognition camera 89 is provided on each of attachment boards 99 of the base 2 so that there are four cameras 83 in total each corresponding to each of the mounting heads 16. The camera 89 sequentially takes images of all the electronic components D picked up by the suction nozzles 15 to detect an amount of shifting from a proper position of the electronic component D on the suction nozzle 15 in X and Y directions and at rotating angles. The camera 89 can also take images of the plurality of the electronic components D at the same time. Furthermore, the component recognition camera 89 can recognize whether or not the electronic component D is held by suction by the suction nozzle 15 by taking an image.

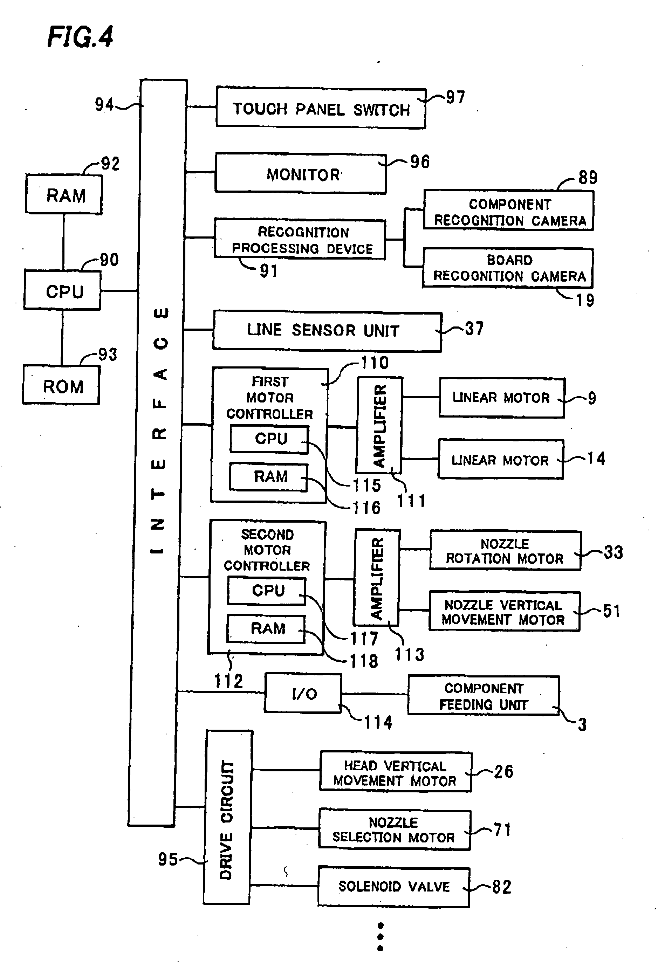

Next, description will be given with reference to a block diagram showing a control of the electronic component mounting apparatus 1 in Fig. 4. A numeral 90 designates a CPU (main control device) as a control portion for controlling the mounting apparatus 1. The CPU 90 is connected with a RAM (random access memory) 92 and a ROM (read only memory) 93 through buses. The CPU 90 controls all operation for component mounting of the electronic component mounting apparatus 1 according to programs stored in the ROM 93 based on data stored in the RAM 92. In detail, the CPU 90 controls the driving of the linear motors 9 and 14 through an interface 94, a first motor controller (a motor control device) 110 and an amplifier 111. The CPU 90 also controls the driving of the nozzle rotation motor 33 and the nozzle vertical movement motor 51 through the interface 94, a second motor controller 112 (a motor control device) and an amplifier 113. The CPU 90 also inputs the state of the component feeding unit 3, for example, the component feeding state through the interface 94 and an I/O 114. Furthermore, the CPU 90 controls the driving of the head vertical movement motor 26, the nozzle selection motor 71, the solenoid valve 82 and so on through the interface 94 and a drive circuit 95.

The first motor controller 110 is provided with a CPU 115 controlling the driving of the start and so on of the linear motors 9 and 14 based on a signal sent from the CPU 90, and a RAM 116 storing setting data sent from the CPU 90. The second motor controller 112 is provided with a CPU 117 controlling the driving of the start and so on of the nozzle rotation motor 33 and the nozzle vertical movement motor 51 based on a signal sent from the CPU 90, and a RAM 118 storing data sent from the CPU 90, that will be described below.

The RAM 92 is stored with mounting data on component mounting which include data on a position in the X and Y directions (indicated by X and Y respectively) indicating the pickup position of an electronic component or the mounting position of an electronic component on a printed board and an angle (indicated by Z) indicating an angle for picking or mounting the electronic component, data on the alignment numbers of the component feeding units 3, data on the movement of the nozzle rotation motor 33 to reach a target position by its rotation based on the angle of the component when the nozzle is selected and the component is picked or mounted, data on the movement of a DD axis (a rotation axis of a nozzle) such as the speed of this movement, data on the movement of an NL axis (a vertical movement axis of a nozzle) that is the data on the movement of the nozzle 15 to reach the target position by its lowering driven by the nozzle vertical movement motor 51 when the suction nozzle lowers for picking the component or mounting the component on the printed board, and so on in order of component mounting (in order of step number). Furthermore, the RAM 92 is stored with component disposition data which include the type of the electronic component (component ID), the alignment coordinates of the component feeding units 3, and so on corresponding to the alignment numbers of the component feeding units 3.

A numeral 91 designates a component recognition processing device connected with the CPU 90 through the interface 94. In the component recognition processing device 91, images taken and stored by the component recognition camera 89 and the board recognition camera 19 undergo recognition processing.

The images taken by the component recognition camera 89 and the board recognition camera 19 are displayed on the CRT 96 as a display device. The CRT 96 is provided with various touch panel switches 97 and an operator operates the touch panel switches 97 for various settings including settings for informing.

The touch panel switches 97 include a glass substrate which is coated with a transparent conductive film on its whole surface and printed with electrodes on its four edges. When an operator touches one of the touch panel switches 97 in a state where minimal electric currents flow on the surface of the touch panel switches 97, current flows change at the four electrodes and coordinates of a touched position are calculated by a circuit board connected with the electrodes. If the calculated coordinates correspond to one of coordinates originally stored in the RAM 92, which will be described below, as a switch for executing a certain operation, the operation is executed.

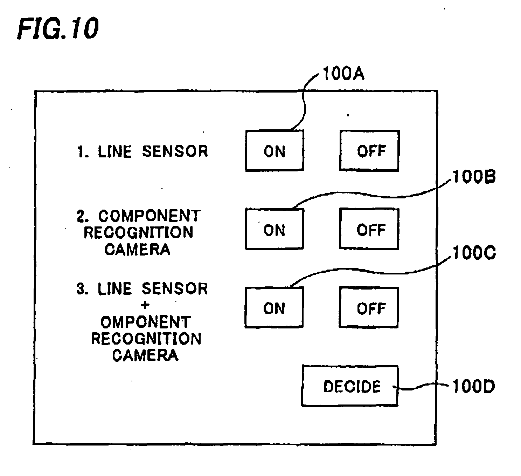

Under the structure described above, a screen as shown in Fig. 10 is displayed on the CRT 96, and then selection is made from the line sensor unit 37 only, the component recognition camera 89 only, and both the line sensor unit 37 and the component recognition camera 89, for use for detecting whether or not the suction nozzle 15 still holds the electronic component after the mounting operation of the electronic component on the printed board P. Suppose that the line sensor unit 37 only is selected for the detection, first. An operator pushes a switch portion 100A and then a decision switch 100D to set the detection by the line sensor unit 37 only. The set content is stored in the RAM 92, and the CPU 90 controls a detecting operation according to a program corresponding to the set content stored in the ROM 93.

This setting can be performed on each group of the electronic components having a same type or in mounting order in the mounting data of electronic components.

Hereafter, the picking and mounting operation of the electronic component D by the electronic component mounting apparatus 1 will be described in detail.

First, the printed board P is conveyed from upstream to the positioning portion 5 through the feed conveyer 4, and the positioning device starts a positioning operation.

Next, the CPU 90 forms pickup sequence data from the mounting data stored in the RAM 92. That is, the CPU 90 reads out data from the mounting data, decides a picking-up procedure of the suction nozzles 15, detects the last component feeding unit 3 which feeds the last electronic component D in a sequential picking-up process (12 components can be picked up for one mounting head 16 at maximum) and stores coordinates of a last pickup position of the component feeding unit 3 in the RAM 92, detects coordinates of a first mounting position of the component D after completing the sequential picking-up process (a position stored in mounting data before alignment) and stores the coordinates in the RAM 92.

Then, the pickup operation of the electronic components D is performed.

In detail, the suction nozzles 15 corresponding to types of the electronic components pick up the electronic components to be mounted from the predetermined component feeding units 3 according to the mounting data and so on stored in the RAM 92 where a position of an X abscissa and a Y ordinate on the printed board to be mounted with the component, a position at a rotation angle around a vertical axis, an alignment number and so on are specified.

First, each of the predetermined component feeding units 3 is driven to start feeding the electronic component to the component pickup position, and the head vertical movement motor 26 rotates based on a signal outputted from the CPU 90 through the interface 94 and the drive circuit 95 to lower the mounting head 16 to a predetermined height along the guide 24.

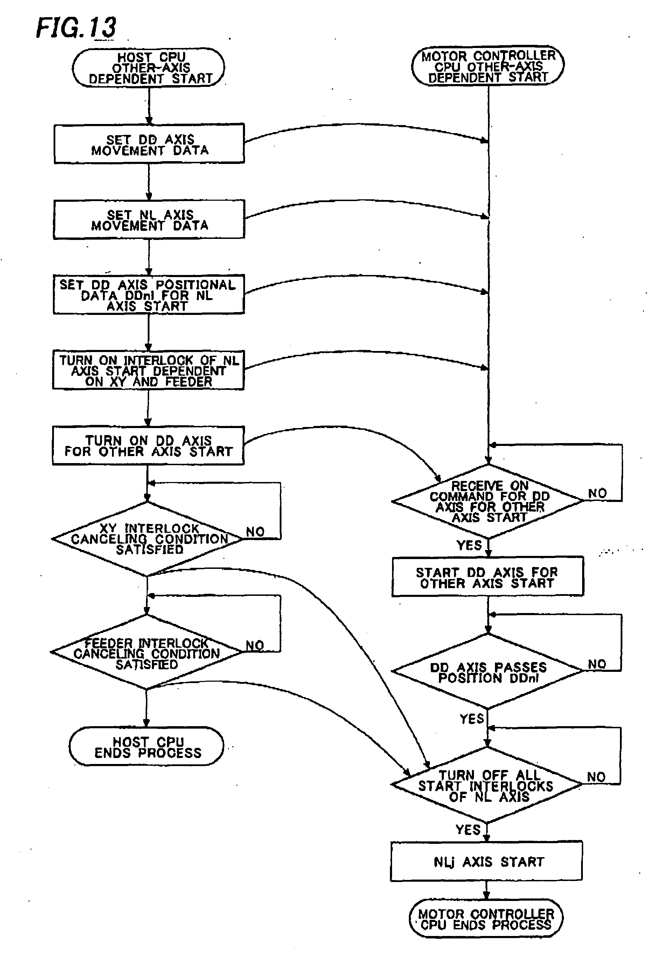

Hereafter, detail description will be given on interlock control for starting the nozzle vertical movement motor 51, i.e., for starting the NL axis as the vertical movement axis of the suction nozzle 15 by the CPU 90 and the CPU 117 (control of other-axis dependent start), based on a flow chart shown in Fig. 13. The term "interlock" is used hereinafter to mean halting the operation of the nozzle vertical movement motor 51, thereby stopping the vertical descent of the suction nozzle 15.

First, data on a position in X and Y directions (indicated by X and Y respectively) indicating the pickup position of an electronic component to be picked and an angle (indicated by Z) indicating an angle for picking the component, data on the movement of the nozzle rotation motor 33 to reach a target position by its rotation based on the angle of the component when the nozzle is selected and the component is picked up, and data on the movement of the DD axis (the rotation axis of the nozzle) such as the speed of this movement are outputted from the CPU 90 to the first motor controller 110, as the setting data, and stored in the RAM 116.

Furthermore, data on the movement of the NL axis (the vertical movement axis of the nozzle) that are the data on the movement of the nozzle 15 to reach a target position by its lowering driven by the nozzle vertical movement motor 51 in order to pick the component are outputted from the CPU 90 to the second motor controller 112, as the setting data, and stored in the RAM 118.

Furthermore, data on the position of the nozzle rotation motor 33 (DD axis positional data: DDnL) that is a condition for starting the nozzle vertical movement motor 51 (for starting the NL axis) are outputted from the CPU 90 to the second motor controller 112, as the setting data, and stored in the RAM 118.

Furthermore, an ON signal (start interlock signal) for the interlock of the start of the nozzle vertical movement motor 51 depending on the position of the suction nozzle 15 on the X and Y axes and the feeding state of the electronic component on the component feeding unit 3 is outputted from the CPU 90 to the second motor controller 112. The second motor controller 112 inputted with the ON signal for the start interlock of the nozzle vertical movement motor 51 stores this in the RAM 118.

Then, for the pickup operation, by the linear motors 9 and 14 controlled by the CPU 90, the suction nozzle 15 of the mounting head 16 in each of the mounting head bodies 7 moves toward the position above the first electronic component on the component feeding unit 3 which has the electronic components to be mounted. Each of the head bodies 7 moves in the Y direction by moving of the beam 8 along the pair of the guides 10 driven by the linear motor 9 and in the X direction along the guides 13 driven by the linear motor 14, both the linear motors 9 and 14 being driven by the drive circuit 95.

Since the suction nozzle 15 for picking the electronic component first (referred to as a first suction nozzle, hereafter) is on a position shifted from a pickup position, i.e., from a pickup position 101 (set this position as 0 degree) shown in Fig. 8 which is a schematic bottom view of the mounting head 16, the CPU 90 outputs a drive signal (ON signal) to the second motor controller 112 in order to move the suction nozzle 15 to the pickup position 101 shown in Fig. 8 (in order to start the DD axis for the other axis start). The second motor controller 112 inputted with this signal judges that it receives a start command for the nozzle rotation motor 33 (a command to start the DD axis for the other axis start) (turns ON) and outputs a drive signal through the amplifier 113, and the nozzle rotation motor 33 starts and rotates (the DD axis starts for the other axis start). By the drive of the nozzle rotation motor 33, the nozzle support body 31 of the mounting head 16 rotates by θ around the center axis 60 (DD axis).

During the nozzle support body 31 of the mounting head 16 is rotating by θ around the center axis 60 by the drive of the nozzle rotation motor 33, the CPU 117 judges whether or not the nozzle rotation motor 33 passes the position of the nozzle rotation motor 33 (DD axis positional data: DDnL) that is the condition for starting the nozzle vertical movement motor 51 (for starting the NL axis) stored in the RAM 118.

When the CPU 117 judges that the nozzle rotation motor 33 passes the position of the nozzle rotation motor 33 that is the condition for starting the nozzle vertical movement motor 51 (for starting the NL axis), i.e., that the roller 65 is already placed on the vertical movement support piece 63 and passes the above-mentioned position based on the rotation angle of the nozzle support body 31 and the angle of the side edge of the vertical movement support piece 63 (the position shifted by 15 degrees from the center of the vertical movement support piece), the CPU 117 judges whether or not the start interlock of the nozzle vertical movement motor 51, i.e. all the start interlocks of the nozzle vertical movement axis turn off.

Then, when the suction nozzle 15 of the mounting head 16 of the mounting head body 7 already completes the movement to above the first electronic component on the component feeding unit 3 having the electronic components to be mounted by the linear motors 9 and 14 controlled by the CPU 90, the CPU 90 judges that the condition for canceling the interlock where the suction nozzle 15 is to complete the movement in the X and Y directions is satisfied, and outputs a signal indicating the satisfaction of the canceling condition to the second motor controller 112. The second motor controller 112 stores the data on the satisfaction of the canceling condition in the RAM 118. Furthermore, when the CPU 90 judges that the feeding of the electronic component is completed based on the data on the completion of feeding the electronic component to the feeding position, that is sent from the component feeding unit 3 to the CPU through the I/O 114 and the interface 94, the CPU 90 judges that the condition for canceling the interlock where the electronic component is to be fed on the electronic component feeding unit 3 is satisfied, and outputs a signal indicating the satisfaction of the canceling condition to the second motor controller 112. Then, the second motor controller 112 stores this data on the satisfaction of the canceling condition in the RAM 118.

The CPU 117 of the second motor controller 112 that receives the signals indicating the satisfaction of the canceling conditions about the movement of the suction nozzle 15 in the X and Y directions and the feeding of the electronic component on the electronic feeding unit 3 immediately outputs a start signal to the nozzle vertical movement motor 51 based on the data of the satisfaction of the canceling conditions stored in the RAM 118.

The nozzle vertical movement motor 51 inputted with the start signal rotates in the direction of lowering the first suction nozzle 15, the vertical movement body 53 and the vertical movement support piece 63 lower by the rotation of the ball screw 52, and the first suction nozzle 15 lowers toward the predetermined height, i.e. the previously set height suitable for picking the electronic component from the feeding unit 3. That is, by the θ rotation of the nozzle support body 31 and the lowering of the vertical movement support piece 63, the first suction nozzle 15 rotates and lowers simultaneously, the roller 65 reaches the center of the vertical movement support piece 63, and the first suction nozzle 15 reaches the pickup position 101 and lowers to the height suitable for picking the electronic component simultaneously.

In this manner, since the first suction nozzle 15 starts lowering during the first suction nozzle 15 is rotating toward the pickup position 101 and the rotation and lowering of the first suction nozzle 15 toward the pickup position 101 are performed simultaneously, the time for the pickup operation of the electronic component D can be reduced.

As described above, the data on the movement pattern of the nozzle vertical movement motor 51, for example, the data on the vertical movement quantity and the velocity of the suction nozzle 15 is sent from the CPU 90 and stored in the RAM 118, the interlock for the start of the nozzle vertical movement motor 51 is turned ON, and then the CPU 117 of the second motor controller 112 immediately outputs a start signal to the nozzle vertical movement motor 51 based on the satisfaction of the interlock canceling condition where the movement of the suction nozzle 15 in the X and Y directions is to be completed and the satisfaction of the interlock canceling condition where the electronic component is to be fed on the electronic component feeding unit 3. Namely, the second motor controller 112 outputs the start signal to the nozzle vertical movement motor 51 based on the satisfaction of all interlock canceling conditions regarding to the nozzle vertical movement motor 51. Therefore, the start signal can be sent to the nozzle vertical movement motor 51 earlier than the conventional case where the CPU 90 sends a start signal to the nozzle vertical movement motor 51 through a motor drive circuit based on its judgment of the completion of the movement of the suction nozzle 15 in the X and Y directions and the completion of the feeding of the electronic component on the electronic component feeding unit 3. As a result of this, the time for mounting the electronic component on the printed board can be reduced.

In the above operation, the CPU 90 simultaneously outputs a signal for moving the suction nozzle 15 to the pickup position 101 shown in Fig. 8 that is the pickup position and a signal for placing the nozzle selection motor 71 in a position corresponding to the first suction nozzle 15 based on the signal from the CPU 90. Therefore, driven by the nozzle rotation motor 33, the nozzle support body 31 of the mounting head 16 rotates around the center axis 60 by θ, and the rotation of the nozzle selection motor 71 is transmitted to the nozzle support member 62 through the first pulley 70, the belt 75, the second pulley 74, and the first cylinder 57 and the rotation of the nozzle support member 62 rotates the vertical movement support piece 63 to reach the position corresponding to the first suction nozzle 15 for the vertical movement.

Since the first suction nozzle 15 does not reach the pickup position 101 yet at this time, the nozzle support body 31 continues the θ rotation around the center axis 60. The CPU 90 outputs a signal to rotate the vertical movement support piece 63 and keep it on the position corresponding to the first suction nozzle 15, and by the rotation of the nozzle support member 62 the vertical movement support piece 63 rotates together with the θ rotation of the nozzle support body 31.

Then, based on the start signal to the nozzle vertical movement motor 51, the nozzle vertical movement motor 51 rotates in a direction of lowering the first suction nozzle 15, the rotation of the ball screw 52 makes the vertical movement body 53 and the vertical movement support piece 63 lower, and the first suction nozzle 15 lowers toward the predetermined height, i.e., the height suitable for picking the electronic component from the predetermined feeding unit 3. That is, by the θ rotation of the nozzle support body 31 and the lowering of the vertical movement support piece 63, the first suction nozzle 15 rotates and lowers simultaneously to reach the pickup position 101 and lower to the height suitable for picking the electronic component simultaneously.

In this manner, the first suction nozzle 15 starts lowering at the time when the first suction nozzle 15 is on the position shifted from the pickup position 101 by 15 degrees or more during it is rotating toward the pickup position 101, and the rotation and lowering of the first suction nozzle 15 toward the pickup position 101 are performed simultaneously, so that the start time of lowering the first suction nozzle 15 can be earlier and also the time for the pickup operation of the electronic component D can be reduced more.

When the first suction nozzle 15 reaches the pickup position 101 and lowers to the height suitable for picking the electronic component simultaneously as described above, the solenoid valve 82 corresponding to the first suction nozzle 15 rises by electrical conduction based on a signal from the CPU 90, and the first suction nozzle 15 is connected to the vacuum source through the nozzle connection path 87 and the solenoid valve 82, so that the first suction nozzle 15 picks and holds the electronic component D by suction.

When the pickup operation of the electronic component by the first suction nozzle 15 is completed as described above, the CPU 90 outputs a signal to the nozzle vertical movement motor 51 through the second motor controller 112, the nozzle vertical movement motor 51 rotates to a rising direction of the first suction nozzle 15 based on this signal, and the vertical movement body 53 rises to the predetermined height, i.e., the height before its lowering by the rotation of the ball screw 52.

Then, the CPU 90 simultaneously outputs a signal to the nozzle vertical movement motor 51 and outputs a signal to pick an electronic component up by a second suction nozzle 15 next to the first suction nozzle 15.

Hereafter, description will be given on the detection of presence or absence and an attached posture of the electronic component by the line sensor unit 37, which follows the pickup operation of the electronic component by each of the suction nozzles 15, with reference to Fig. 8.

The light receiving unit 46 of the line sensor unit 37 is provided in a position shifted by 45 degrees from the pickup position 101 shown in Fig. 8, for example. When the suction nozzle 15 holding the electronic component by suction passes a detection position 102 shown in Fig. 8 by intermittent rotation of the nozzle support body 31 in a direction shown by an arrow, the detection of presence or absence and an attached posture of.the electronic component is performed at a lower end of the suction nozzle 15 by the line sensor unit 37 as described above.

In a case where the electronic component is detected as being attached to the suction nozzle 15 at its wrong surface, i.e., with standing or slanting, the mounting head 16 and the suction nozzle 15 move to a position above an exhaust box 79, drops the electronic component D therein, and performs a picking process of the electronic component D again. In a case where the electronic component is detected as being attached normally, the vacuum suction is kept and a lower end level (lower end position) of the electronic component D can be detected, so that the CPU 90 controls the nozzle vertical movement motor 51 so as to change an amount of a lowering stroke of the suction nozzle 15 for mounting the component D on the printed board P corresponding to the lower end level. This can compensate dimensional variations of the components caused by different manufacturers and on.

By controlling the drive of the nozzle vertical movement motor 51, the ball screw 52 is rotated by predetermined angles to lower the vertical movement body 53, and then the vertical movement support piece 63 lowers, thereby lowering the suction nozzle 15 by a predetermined stroke for mounting the electronic component D.

At the time when a last suction nozzle, for example, a twelfth suction nozzle 15 among the twelve suction nozzles 15 picks the electronic component by suction, this twelfth suction nozzle 15 is positioned in the pickup position 101 and the previous eleventh suction nozzle is positioned in a stop position 103 next to the pickup position 101.

Therefore, the CPU 90 outputs a signal to the nozzle rotation motor 33 to intermittently rotate the nozzle support body 31 by 30 degrees two times. Then, first the electronic component held by the eleventh suction nozzle 15 passes the detection position 102, and the detection of presence or absence and an attached posture of the electronic component is performed by the line sensor unit 37. Then, the electronic component held by the twelfth suction nozzle 15 passes the detection position 102, and the detection of presence or absence and an attached posture of the electronic component is performed by the line sensor unit 37 similarly, thereby completing the detection of presence or absence and an attached posture of all the electronic components held by the suction nozzles 15.

When the pickup operation of the electronic component by each of the suction nozzles 15 and the detection of presence or absence and an attached posture of the electronic component on each of the suction nozzles 15 are completed, the CPU 90 forms a mounting sequence data. In a case where the electronic component held by each of the suction nozzles 15 is thick, for example, the CPU 90 outputs a signal to raise the mounting head 16, i.e. the mounting head body 7 so as to position the electronic component within a focus range of the component recognition camera 89 when the component recognition camera 89 performs component recognition processing. Based on this signal, the head vertical movement motor 26 rotates in a reverse direction to the direction for lowering. As a result, by actions of the ball screw 25 and the vertical movement nut 28, the mounting head body 7 starts rising to a predetermined height, i.e. a height where the electronic component can be positioned within the focus range of the component recognition camera 89.

In a case where the electronic component held by each of the suction nozzles 15 is thin, for example, and the electronic component can be positioned within the focus range of the component recognition camera 89 when each of the suction nozzles 15 of the nozzle support body 31 rises, the raising operation of the mounting head body 7 is not performed.

Accordingly, in the electronic component mounting apparatus 1, the height where the suction nozzle 15 picks the electronic component can be adjusted not only by the vertical movement of the suction nozzle 15 by the nozzle support body 31 but also by the vertical movement of the mounting head body 7 by the operation of the head vertical movement device 23, so that an adjusting range can be increased. This can increase a range of the electronic components to be picked up by the suction nozzle 15 of the mounting head 7 and mounted on the printed board.

At the same time when the raising operation starts in a case where the raising operation is performed, or after the set last suction nozzle 15 picks the electronic component in a case where the raising operation is not performed, the CPU 90 outputs a signal so that the mounting head 16 passes above the component recognition camera 89 and moves to a position of mounting coordinates on the printed board P positioned by the positioning portion 5. Based on the signal from the CPU 90, the linear motors 9 and 14 are controlled, and each of the mounting head bodies 7 moves in the Y direction by moving of the beam 8 along the pair of the guides 10 driven by the linear motor 9 and in the X direction along the guides 13 driven by the linear motor 14, both the linear motors 9 and 14 being driven by the drive circuit 95.

During the movement of the head body 7, the mounting head 16 passes above the component recognition cameras 89, and the component recognition cameras 89 simultaneously take and store images of all the electronic components D picked up by the suction nozzles 15 of the mounting head 16 by "on the fly recognition without stopping of the beam 8". Then, the component recognition processing device 91 starts a component recognition process.

After a recognition result for the first component to be mounted is calculated by the component recognition processing device 91, the CPU detects whether the suction nozzle 15 is positioned on a first mounting position (a position in mounting data before alignment of a pickup position) which is set as the coordinate value of the moving target position. If positioned, the CPU resets the coordinate value into a coordinate value of a moving target position calculated with the recognition (alignment) result and moves the beam 8 for positioning the suction nozzle 15 on a position of the reset target value. If not positioned, the set coordinate value of the moving target position is dynamically changed to the coordinate value calculated with the recognition (alignment) result.

Furthermore, based on the recognition result of the component recognition processing device 91, the CPU 90 calculates a pickup angle of the electronic component on each of the suction nozzles 15. Then, the CPU 90 compares a calculation result and a mounting angle in the mounting data stored in the RAM 92. In a case where there is a difference between the calculated pickup angle and the mounting angle, the CPU 90 outputs a signal to correct the pickup angle to the mounting angle, to the nozzle rotation motor 33. Then, the nozzle rotation motor 33 starts rotating during the mounting head body 7 is moving toward above the printed board, and this rotation makes the pickup angle of the electronic component on the suction nozzle corrected to the mounting angle.

The mounting head body 7 continues its movement even after passing above the component recognition camera 89. In a case where the mounting head body 7 rises as described above, the CPU 90 outputs a signal to lower the mounting head body 7 during the movement. Then, the head vertical movement motor 26 rotates based on this signal, and by the rotation of the ball screw 25 the mounting head body 7 lowers to a height where the mounting head body 7 has been before it rises and reaches above the printed board. Then, the first electronic component D among the electronic components D is mounted on the printed board D.

Hereafter, description will be given on the mounting operation of the electronic component on the printed board by the suction nozzle 15. In the following description, the order of suction nozzles for mounting is the same as those for picking described above.

In the mounting operation, the first electronic component D held by suction by the first suction nozzle reaches the position of mounting coordinates by the movement of the mounting head body 7, and the first electronic component D is mounted on the printed board P by lowering the suction nozzle 15 by a predetermined stroke corresponding to the thickness of the electronic component D and the detection value of the lower end level of the electronic component D by the line sensor unit 37.

In this mounting operation, the CPU 90 outputs a signal to lower the suction nozzle 15 in the similar manner to the case of the pickup operation of the electronic component described above. Based on this signal, the nozzle vertical movement motor 51 rotates in the direction for lowering the first suction nozzle 15 and the ball screw 52 rotates, and thus the vertical movement body 53 lowers corresponding to the thickness of the electronic component D and the detection value of the lower end level of the electronic component D detected by the line sensor unit 37, so that the suction nozzle 15 lowers by a predetermined stroke and mounts the electronic component D on the printed board P.

When the suction nozzle 15 lowers, the solenoid valve 82 corresponding to the first suction nozzle 15 lowers by switching from electrical conduction to electrical non-conduction based on the signal from the CPU 90 and disconnects the first suction nozzle 15 from the vacuum source, so that the first suction nozzle 15 stops the vacuum suction operation. Then, air from the air supply source is blown in the inner path 151 of the first suction nozzle 15 through the air path 86 and the nozzle connection path 87.

The CPU 90 calculates next mounting operation of the electronic component D and repeats the mounting operation until all the picked electronic components D are mounted.

In detail, the CPU 90 receives a recognition result calculated by the component recognition processing device 91, calculates a coordinate value of a moving target position in X, Y, and θ. Then, the CPU 90 drives the linear motor 9 to move the beam 8 in the Y direction to a target coordinate value calculated with the recognition result, drives the linear motor 14 to move the mounting head 16 in the X direction, drives the nozzle rotation motor 33 to rotate the nozzle support body 31 by θ, and rotates the suction nozzle 15. The CPU 90 also rotates the nozzle vertical movement motor 51, lowers the suction nozzle 15 by a predetermined stroke corresponding to the thickness of the component D, mounts the electronic component D on the printed board P, and then raises the suction nozzle 15 up. The CPU repeats this operation until all the electronic components D picked up by the suction nozzles 15 of the mounting head 16 are mounted on the printed board.

When the electronic component is mounted as described above, in a case where the mounting angle does not differ in each of the mounting operations, the nozzle support body 31 rotates by a predetermined angle, i.e. by 30 degrees in each time when the mounting operation is completed, so that the suction nozzles 15 are sequentially positioned at a predetermined angle, that is, in the same position as the pickup position 101 shown in Fig. 8, and the vertical movement of the suction nozzle 15 is performed in this position. On the other hand, in a case where the pickup angle of the electronic component on the suction nozzle 15 differs from the mounting angle of the electronic component in the electronic component mounting operation, or in a case where the pickup angle is shifted from the set mounting angle by recognizing the electronic component by the component recognition camera 89, the nozzle support body 31 is rotated by a shifting amount from the predetermined angle calculated from a relation between the pickup angle of the component on the suction nozzle 15 and the mounting angle. Furthermore, in a case where the position of the suction nozzle 15 is shifted from the pickup position 101, the CPU 90 outputs a signal to the nozzle selection motor 71 corresponding to a shifting amount of angle. Therefore, the vertical movement support piece 63 rotates by the rotation of the nozzle support body 31 when the component is to be mounted, and stops at a position corresponding to the suction nozzle 15 to be vertically moved. The suction nozzle 15 vertically moves in this position.

In detail, in a case where the pickup angle of the electronic component held by the suction nozzle 15 by suction differs from the mounting angle and thus the nozzle support body 31 is rotated, the nozzle selection motor 71 is rotated according to the rotation of the nozzle support body 31, and then the vertical movement support piece 63 is rotated and comes to the position corresponding to the suction nozzle 15 to be vertically moved. Thus, by vertically moving the suction nozzle 15, the electronic component can be mounted on the printed board without fail, thereby improving accuracy in the mounting operation.

Although the description of the pickup and the mounting of the electronic component D is given on the picking and mounting operation by one mounting head body 7 among four mounting head bodies 7 provided in the electronic component mounting apparatus 1, other mounting head bodies 7 also perform the picking and mounting operations of the electronic components similarly.

Then, the CPU 90 checks whether or not the brought-back component checking function is set. When the brought-back component checking function is not set, that is, the RAM 92 does not have a setting content of the brought-back component checking function, the electronic component pickup operation according to the next mounting data, which is described above, will be performed.

Here, when the RAM 92 has the setting content of the brought-back component checking function, the CPU 90 checks whether or not a component checking function by the line sensor unit 37 is set. When the RAM 92 does not have a setting content of the component checking function by the line sensor unit 37, the electronic component pickup operation according to the next mounting data, which is described above, will be performed. When the RAM 92 has the setting content of the component checking function by the line sensor unit 37, the line sensor unit 37 performs detection of presence or absence of the electronic component by rotating the nozzle support body 31 as described above while the suction nozzle 15 of the mounting head 16 is moving to each of the component feeding units 3 storing the electronic component for next mounting.

When a result of the detection of presence or absence of the electronic component performed by the line sensor unit 37 is "absence", the pickup operation of the electronic component for next mounting starts. When the result is "presence", the CPU 90 checks whether or not the RAM 92 has a setting content of an error stop function. When the RAM 92 has the setting content of the error stop function, the CPU 90 controls the electronic component mounting apparatus 1 to stop the operation. When the RAM 92 does not have the setting content of the error stop function, the CPU 90 controls the suction nozzle 15 to move to a position above the exhaust box 79 and perform a discharging operation of the electronic component D.

After the discharging operation, the CPU 90 checks whether or not a setting content of a nozzle skip function is stored in the RAM 92. When the nozzle skip function is not stored in the RAM 92, a pickup operation of a next electronic component to be picked up starts. When the nozzle skip function is stored in the RAM 92, a skip process is performed to the appropriate suction nozzle 15 and the pickup operation of the next electronic component to be picked up starts.

There are twelve suction nozzles 15 attached to the mounting head 16 and some of the suction nozzles 15 are of same type. In the skip process, the CPU 90 controls so that the suction nozzle 15 which brings back the electronic component is not used but the other suction nozzle 15 of same type is used instead.

When all the electronic components D specified in the mounting data are not mounted on the printed board P, the pickup sequence data is formed again as described above, and the pickup operation, the component recognition processing, and the mounting operation of the electronic components D are performed. When all the electronic components D specified in the mounting data are mounted on the printed board P, the beam 8 is returned to an original position, and the printed board P completing component mounting is mounted on the discharging conveyer 6, completing the mounting operation.

In the next case, the screen as shown in Fig. 10 is displayed on the CRT 96, and then the component recognition camera 89 only is selected for use for detecting whether or not the suction nozzle 15 still holds the electronic component after the component mounting operation on the printed board P. An operator pushes a switch portion 100B and then the decision switch 100D to set the detection by the component recognition camera 89 only. The CPU then controls a detecting operation according to a program corresponding to the set content stored in the ROM 93.

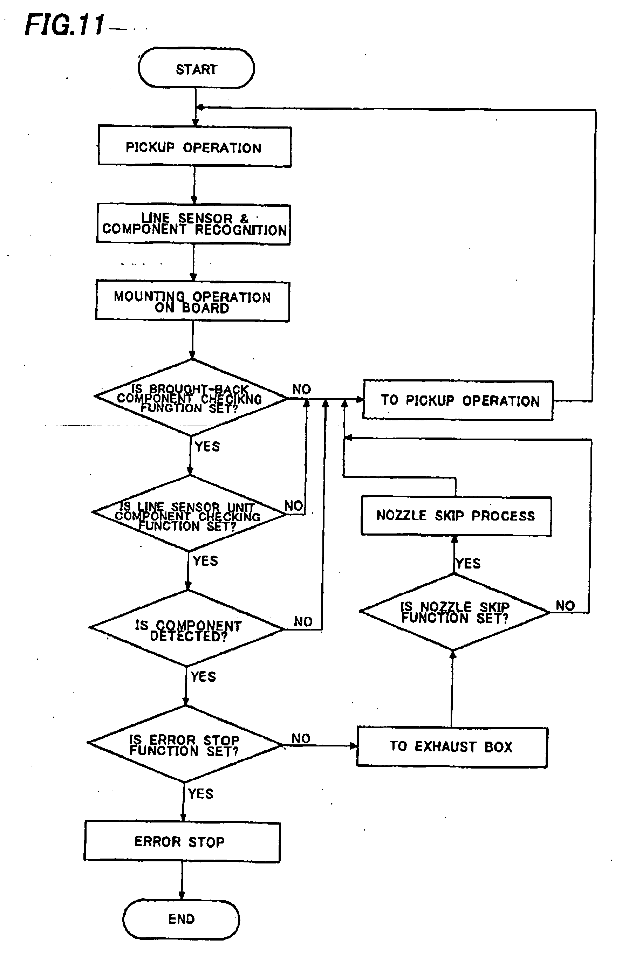

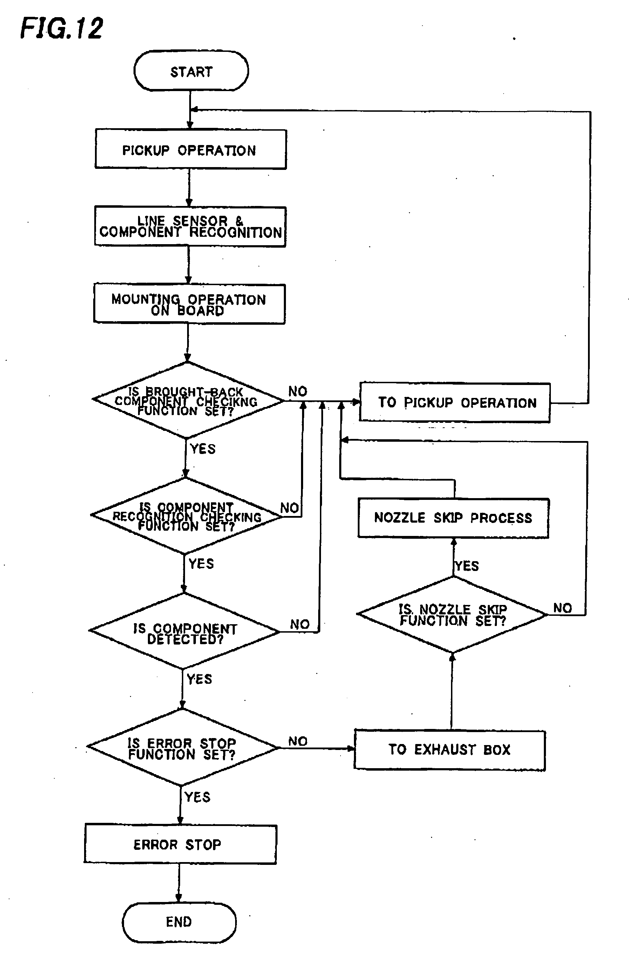

That is, control shown in a flow chart shown in Fig. 12 is performed. In this control, detection processing of the brought-back electronic component as shown in Fig. 11 is performed by the component recognition camera 89 and the component recognition processing device 91 only, instead of by the line sensor unit 37.

In the explanation below, some features of the mounting operation that have been already explained with respect to the line sensor unit only detection will be omitted. First, the printed board P is conveyed to the positioning portion 5 and positioned there, and the CPU 90 forms pickup sequence data from the mounting data stored in the RAM 92. Then, the cameras 89 can simultaneously take images of all the electronic components picked up by the suction nozzles 15 of the mounting head 16 by "on the fly recognition without stopping of the beam 8" at the time when the beam 8 is moving from the last pickup position to the first mounting position which will be described below.

Then, the suction nozzle 15 corresponding to type of the electronic component picks up the electronic component to be mounted from the predetermined component feeding unit 3 according to the mounting data and so on. After picking up the electronic component D, the suction nozzle 15 rises up by the rotation of the nozzle vertical movement motor 51, and the nozzle rotation motor 33 is driven to rotate the nozzle support body 31 and the suction nozzle 15. The picked electronic component D is positioned between the reflector 44 and the light receiving unit 46 during this rotation, so that detection of presence or absence and an attached posture of the electronic component D is performed by the line sensor unit 37.

When the electronic component D is detected as being attached normally, while keeping vacuum suction, a lower end level of the electronic component D can be detected so that the CPU 90 controls the nozzle vertical movement motor 51 to change an amount of a lowering stroke of the suction nozzle 15 for mounting the component D on the printed board P corresponding to the lower end level. This compensates dimensional variations of the components caused by different manufacturers and so on.

After that, multiple picking (sequential pickup of the components as much as possible) is performed, similarly. When completing this multiple pickup operation, the CPU 90 forms mounting sequence data and moves the beam 8 and the mounting head body 7 to a first mounting position where the component D is mounted on the printed board P first.

Then, when the CPU 90 detects timing for the component recognition cameras 89 to take images, the CPU makes the cameras 89 simultaneously take and store images of all the electronic components D picked up by the suction nozzles 15 of the mounting head 16 by "on the fly recognition without stopping of the beam 8" while the beam 8 is moving from the last pickup position to the first mounting position. Then, the component recognition processing device 91 starts a component recognition process.

When moving of the beam 8 is completed, the first electronic component D among the components D sequentially picked up is mounted on the printed board P. The CPU 90 calculates a next mounting operation of the other electronic component D, and repeats the mounting operation until all the picked electronic components D are mounted.

Then, the CPU 90 checks whether or not the brought-back component checking function is set. When the brought-back component checking function is not set, that is, the RAM 92 does not have a setting content of the brought-back component checking function, the electronic component pickup operation according to the next mounting data, which is described above, will be performed.

When the RAM 92 has the setting content of the brought-back component checking function, the CPU 90 checks whether or not a component checking function by the component recognition camera 89 and the component recognition processing device 91 is set. When the RAM 92 does not have a setting content of the component checking function by the component recognition camera 89 and the component recognition processing device 91, the electronic component pickup operation according to the next mounting data, which is described above, will be performed. When the RAM 92 has the setting content of the component checking function by the component recognition camera 89 and the component recognition processing device 91, the component recognition camera 89 takes an image and the component recognition processing device 91 performs recognition processing based on the image taken to perform the detection of presence or absence of the electronic component while the suction nozzle 15 of the mounting head 16 is moving to the component feeding unit 3 storing the electronic component for next mounting.

When a result of the detection of presence or absence of the electronic component D performed by the component recognition camera 89 and the component recognition processing device 91 is "absence", the pickup operation of the electronic component for next mounting starts. On the contrary, when the result is "presence", the CPU 90 checks whether or not the RAM 92 has the setting content of the error stop function. When the RAM 92 has the setting content of the error stop function, the CPU 90 controls the electronic component mounting apparatus 1 to stop the operation. When the RAM 92 does not have the setting content of the error stop function, the CPU 90 controls the suction nozzle 15 to move to a position above the exhaust box 79 and perform a discharging operation of the electronic component D.

After the discharging operation, the CPU 90 checks whether or not the setting content of the nozzle skip function is stored in the RAM 92. When the nozzle skip function is not stored in the RAM 92, a pickup operation of a next electronic component to be picked up starts. When the nozzle skip function is stored in the RAM 92, the skip process is performed to the appropriate suction nozzle 15 and the pickup operation of the next electronic component to be picked up starts.

That is, there are twelve suction nozzles 15 attached to the mounting head 16 and some of the suction nozzles 15 are of same type. In the skip process, the CPU 90 controls so that the suction nozzle 15 which brings back the electronic component D is not used but the other suction nozzle 15 of same type is used instead.

When all the electronic components D specified in the mounting data are not mounted on the printed board P, the pickup sequence data is formed again as described above, and the pickup operation, the component recognition processing, and the mounting operation of the electronic component D are performed. When all the electronic components D specified in the mounting data are mounted on the printed board P, the beam 8 is returned to an original position, and the printed board P completing component mounting is mounted on the discharging conveyer 6, completing the mounting operation.

In the next case, the screen as shown in Fig. 10 is displayed on the CRT 96, and then the line sensor unit 37 and the component recognition camera 89 are selected for use for detecting whether or not the suction nozzle 15 still holds the electronic component for mounting, which is small, after the component mounting operation on the printed board P. An operator pushes a switch portion 100C and then the decision switch 100D to set the detection by the line sensor unit 37 and the component recognition camera 89. The CPU 90 then controls a detecting operation according to a program corresponding to the set content stored in the ROM 93. This selection increases certainty in detection of presence or absence of an electronic component, since the detection result is "error" when either the line sensor unit 37 or the component recognition camera 89 detects the electronic component.

During the mounting head body 7 is moving to the component mounting position, the lowering amount of the mounting head body 7 when lowering to the height where the mounting head body 7 has been before it rises for the component recognition differs based on the thickness of the electronic component D held by the suction nozzle 15, the height of the chute of the positioning portion 5, and the height of the electronic component D already mounted on the printed board P. For example, when the electronic component held by the suction nozzle 15 is thick, the lowering amount is controlled to be small. Accordingly, in addition to the capability of adjusting the lowering amount of the mounting head body 7, the rising amount of the electronic component held by the suction nozzle 15 can be increased by raising the suction nozzle 15 and the mounting head body 7 when the electronic component held by the suction nozzle 15 need be raised because of the height of the electronic component D already mounted on the printed board. This can broaden the range of thicknesses of the mountable electronic components, compared with the case where only the suction nozzle 15 is vertically moved.

In the above embodiment, the description is given on the electronic component mounting apparatus where two mounting head bodies 7 are slidably provided on each of the two beams 8 each being independently slidable. However, the same effect can be obtained in the electronic component mounting apparatus where a beam is provided on each of front, back, left, and right sides, being independently slidable, and a mounting head body is provided in each of the four beams, for example, as long as the mounting head body has the same structure as that of the embodiment described above.

Although particular preferred embodiment of the invention has been disclosed in detail, it will be recognized that variations or modifications of the disclosed apparatus are possible based on the disclosure for those skilled in the art and lie within the scope of the present invention.

## Claims

1. An electronic component mounting apparatus comprising:
- a component feeding unit (3) configured for feeding an electronic component to a component pickup position;
- a mounting head (16) comprising a suction nozzle (15) configured for picking up the electronic component by suction from the component pickup position and mounting the electronic component on a printed board (P);
- a rotation motor (33) configured for rotating the suction nozzle (15);
- a vertical movement motor (51) configured for vertically moving the suction nozzle (15),
- a first axis motor (9) configured for moving the mounting head (16) in a first direction along a beam (8);
- a second axis motor (14) configured for moving the beam (8) in a second direction normal to a longitudinal direction of the beam (8);
- a control device (90) configured for outputting a start interlock signal for halting the vertical movement motor (51) and outputting a start interlock canceling signal when the control device (90) finds that an interlock canceling condition is satisfied;
- a motor control device (117) configured for halting the vertical movement motor (51) in response to the start interlock signal and configured for starting the vertical movement motor (51) in response to the start interlock canceling signal;
**characterized in that**
- the control device (90) is configured for outputting the start interlock canceling signal when the control device (90) finds that a plurality of interlock canceling conditions is satisfied.

2. The electronic component mounting apparatus of claim 1, further comprising a storage device (118) storing data on cancellation of the halting of the vertical movement motor (51) in response to the start interlock canceling signal, wherein the motor control device (117) starts the vertical movement motor (51) based on the stored data.

3. The electronic component mounting apparatus of claim 1 or 2, wherein the interlock canceling condition is satisfied when the suction nozzle (15) completes movement in the first and second directions and the electronic component is fed to the component pickup position.

4. The electronic component mounting apparatus of claim 1 or 2, wherein the interlock canceling condition is satisfied when the suction nozzle (15) rotates to a predetermined angular position.

5. The electronic component mounting apparatus of claims 1 to 4, wherein the control device (90, 117) controls the rotation motor (33) and the vertical movement motor (51) so that the suction nozzle (15) rotates to a predetermined angular position without descent and after the rotation to the predetermined angular position the suction nozzle (15) rotates and descends simultaneously.

## Patentansprüche

1. Vorrichtung zur Montage von elektronischen Bauteilen, umfassend:
- eine Bauteilzuführungseinheit (3), die zur Zuführung eines elektronischen Bauteils in eine Bauteilaufnahmeposition konfiguriert ist;
- einen Montagekopf (16), der eine Saugdüse (15) umfasst, die zur Aufnahme des elektronischen Bauteils durch Ansaugen aus der Bauteilaufnahmeposition und zur Montage des elektronischen Bauteils auf einer Leiterplatte (P) konfiguriert ist;
- einen Drehmotor (33), der zum Drehen der Saugdüse (15) konfiguriert ist;
- einen Vertikalbewegungsmotor (51), der zur Vertikalbewegung der Saugdüse (15) konfiguriert ist;
- einen Motor (9) für eine erste Achse, der zum Bewegen des Montagekopfs (16) in einer ersten Richtung entlang einem Träger (8) konfiguriert ist;
- einen Motor (14) für eine zweite Achse, der zum Bewegen des Trägers (8) in einer zweiten Richtung normal zu einer Längsrichtung des Trägers (8) konfiguriert ist,
- eine Steuervorrichtung (90), die zur Ausgabe eines Startverriegelungssignals zum Anhalten des Vertikalbewegungsmotors (51) konfiguriert ist und zur Ausgabe eines Startverriegelungsaufhebungssignals, wenn die Steuervorrichtung (90) feststellt, dass eine Verriegelungsaufhebungsbedingung erfüllt ist, konfiguriert ist;
- eine Motorsteuervorrichtung (117), die zum Anhalten des Vertikalbewegungsmotors (51) als Reaktion auf das Startverriegelungssignal konfiguriert ist und zum Starten des Vertikalbewegungsmotors (51) als Reaktion auf das Startverriegelungsaufhebungssignal konfiguriert ist;
**dadurch gekennzeichnet, dass**
- die Steuervorrichtung (90) zur Ausgabe des Start verriegelungsaufhebungssignals, wenn die Steuervorrichtung (90) feststellt, dass mehrere Verriegelungsaufhebungsbedingungen erfüllt sind, konfiguriert ist.

2. Vorrichtung zur Montage von elektronischen Bauteilen nach Anspruch 1, die weiterhin eine Speichervorrichtung (118) umfasst, die Daten über die Aufhebung des Anhaltens des Vertikalbewegungsmotors (51) als Reaktion auf das Start verriegelungsaufhebungssignal umfasst, wobei die Motorsteuervorrichtung (117) den Vertikalbewegungsmotor (51) auf Grundlage der gespeicherten Daten startet.

3. Vorrichtung zur Montage von elektronischen Bauteilen nach Anspruch 1 oder 2, wobei die Verriegelungsaufhebungsbedingung erfüllt ist, wenn die Saugdüse (15) eine Bewegung in die erste und zweite Richtung beendet und das elektronische Bauteil der Bauteilaufnahmeposition zugeführt wird.

4. Vorrichtung zur Montage von elektronischen Bauteilen nach Anspruch 1 oder 2, wobei die Verriegelungsaufhebungsbedingung erfüllt ist, wenn sich die Saugdüse (15) in eine vorbestimmte Winkelposition dreht.

5. Vorrichtung zur Montage von elektronischen Bauteilen nach den Ansprüchen 1 bis 4, wobei die Steuervorrichtung (90, 117) den Drehmotor (33) und den Vertikalbewegungsmotor (51) so steuert, dass sich die Saugdüse (15) ohne Abwärtsbewegung in eine vorbestimmte Winkelposition dreht und sich die Saugdüse (15) nach der Drehung in die vorbestimmte Winkelposition dreht und gleichzeitig nach unten bewegt.

## Revendications

1. Appareil de montage de composant électronique comprenant:
- une unité d'approvisionnement de composant (3) configurée pour approvisionner un composant électronique à une position de prélèvement de composant électronique;
- une tête de montage (16) comprenant une buse d'aspiration (15) configurée pour prélever le composant électronique par aspiration depuis la position de prélèvement de composant électronique et monter le composant électronique sur une carte de circuit imprimé (P);
- un moteur de rotation (33) configuré pour faire tourner la buse d'aspiration (15);
- un moteur de mouvement vertical (51) configuré pour déplacer verticalement la buse d'aspiration (15),
- un premier moteur d'axe (9) configuré pour déplacer la tête de montage (16) dans une première direction le long d'une traverse (8);
- un second moteur d'axe (14) configuré pour déplacer la traverse (8) dans une seconde direction perpendiculaire à une direction longitudinale de la traverse (8);
- un dispositif de commande (90) configuré pour émettre un signal de verrouillage de démarrage permettant d'arrêter le moteur de mouvement vertical (51) et pour émettre un signal d'annulation de verrouillage de démarrage lorsque le dispositif de commande (90) trouve qu'une condition d'annulation de verrouillage est satisfaite;
- un dispositif de commande de moteur (117) configuré pour arrêter le moteur de mouvement vertical (51) en réponse au signal de verrouillage de démarrage et configuré pour démarrer le moteur de mouvement vertical (51) en réponse au signal d'annulation de verrouillage de démarrage;
**caractérisé en ce que**
- le dispositif de commande (90) est configuré pour émettre le signal d'annulation de verrouillage de démarrage lorsque le dispositif de commande (90) trouve qu'une pluralité de conditions d'annulation de verrouillage sont satisfaites.

2. Appareil de montage de composant électronique selon la revendication 1, comprenant en outre un dispositif de stockage (118) stockant des données sur l'annulation de l'arrêt du moteur de mouvement vertical (51) en réponse au signal d'annulation de verrouillage de démarrage, dans lequel le dispositif de commande de moteur (117) démarre le moteur de mouvement vertical (51) sur la base des données stockées.

3. Appareil de montage de composant électronique selon la revendication 1 ou 2, dans lequel la condition d'annulation de verrouillage est satisfaite lorsque la buse d'aspiration (15) accomplit un mouvement dans les première et seconde directions et que le composant électronique est approvisionné à la position de prélèvement de composant électronique.

4. Appareil de montage de composant électronique selon la revendication 1 ou 2, dans lequel la condition d'annulation de verrouillage est satisfaite lorsque la buse d'aspiration (15) pivote à une position angulaire prédéterminée.

5. Appareil de montage de composant électronique selon les revendications 1 à 4, dans lequel le dispositif de commande (90, 117) commande le moteur de rotation (33) et le moteur de mouvement vertical (51) de sorte que la buse d'aspiration (15) pivote à une position angulaire prédéterminée sans descendre et que, après le pivotement à la position angulaire prédéterminée, la buse d'aspiration (15) pivote et descende simultanément.
